# EUROPEAN PATENT APPLICATION

(11) **EP 2 631 477 A2**
(43) Date of publication of application: **28.08.2013**
(21) Application number: 13156261.3
(22) Date of filing: 22.02.2013
(51) Int. Cl.: F03D 11/02, F03D 11/00

(54) **Monitoring method and system for wind turbine generator**

(30) Priority: 23.02.2012 JP 2012037183
(71) Applicant: MITSUBISHI HEAVY INDUSTRIES, LTD., Tokyo 108-8215 (JP)
(72) Inventor: Nakamura, Shigeaki, Tokyo, 108-8215 (JP); Hamano, Fumio, Tokyo, 108-5215 (JP); Hashimoto, Jun, Tokyo, 108-5215 (JP); Hayashi, Toshikazu, Tokyo, 108-5215 (JP); Mori, Shinichiro, Tokyo, 108-5215 (JP)
(74) Representative: Intès, Didier Gérard André

(57) **Abstract**

In a method for monitoring a wind turbine generator (1) configured to generate power by transmitting energy of wind from a rotor (4) including a blade (5) and a hub (6) to a generator (18) via an energy transmission pathway arranged from the rotor (4) to the generator (18): energy transmission efficiency in a monitoring object part located on the energy transmission pathway, such as a hydraulic transmission (10), is calculated from input energy inputted to the monitoring object part and output energy outputted from the monitoring object part; temporal change of the energy transmission efficiency is obtained from the calculated energy transmission efficiency in the past; energy transmission efficiency in the future is estimated based on the temporal change; and maintenance timing is determined based on the estimated energy transmission efficiency.

## Description

### [Technical Field]

The present invention relates to a monitoring method and a monitoring system for a wind turbine generator configured to transmit rotational energy from a rotor to a generator via an energy transmission pathway, and in particular, to a monitoring method and a monitoring system for the wind turbine generator, that are capable of knowing appropriate maintenance timing based on a state of a part of the wind turbine generator.

### [Background Art]

From a perspective of preserving the environment, wind turbine generators using force of wind in a form of renewable energy are becoming popular. A wind turbine generator is normally provided with a rotor having a plurality of blades mounted to a hub and energy of the wind inputted from the rotor is transmitted to the generator via a main shaft and a speed increaser, thereby generating power.

This type of wind turbine generator is formed by many components. Among these components, age-related deterioration is unavoidable for the components for transmitting energy such as blades, a speed increaser of gear type or hydraulic transmission type and a generator. Thus, it is necessary to perform maintenance on these components before deterioration becomes so serious that complete shutdown of the wind turbine is needed. Normally, scheduled maintenance is performed after a set period of time in view of performance decline of the components.
However, output of the wind turbine generator changes from moment to moment in accordance to wind speed and thus deterioration speed of the components are different for each wind turbine generator and thus, it is difficult to set the maintenance timing uniformly for the wind turbine generators. More specifically, for the wind turbine generator whose components deteriorate faster, damage or excessive deterioration of the components may occur before the scheduled maintenance. Then, the wind turbine generator may fail to perform as originally designed to or be forced to shutdown. Therefore, it is critical to avoid unexpected shutdown of the wind turbine by monitoring state of the components of the wind turbine and performing maintenance at appropriate timing.

Patent Literature 1 describes an operation method of the wind turbine generator. According to the operation method, a condition monitoring system, CMS estimates the remaining lifetime of the component based on vibration of a speed increaser or a generator detected by an acceleration sensor and output (power production) is controlled to adjust the remaining lifetime to a desired remaining lifetime. For instance, if it is estimated that the remaining lifetime of the component won't last until the next scheduled maintenance, the output is lowered so as to prolong the remaining lifetime of the component to reach the time of the next scheduled maintenance. As a result, it is possible to avoid unexpected shutdown of the wind turbine generator due to failure of the component.

### [Citation List]

### [Patent Literature]

[PTL 1]
US 2010/0332272 A

### [Summary]

### [Technical Problem]

According to the monitoring method of Patent Literature 1, the remaining lifetime of the component is estimated from detection results of the acceleration sensor by considering cause of deterioration only that results in vibration of the component. Thus, it is difficult to know failure of the component which does not result in vibration of the component. For instance, in the case of the wind turbine generator having the hydraulic transmission, if there is an oil leak in an oil line of the hydraulic transmission, power transmission efficiency of the speed increaser declines but does not necessarily cause vibration of the hydraulic transmission. With the monitoring technique of Patent Literature 1, such failure is not detectable. Thus, it is difficult to perform maintenance at appropriate timing and thus it is difficult to avoid unexpected shutdown of the wind turbine generator while attaining intended performance of the wind turbine generator.

In view of the above issues, it is an object of the present invention to provide a monitoring method and a system for a wind turbine generator that are capable of setting appropriate maintenance timing in accordance with the state of the wind turbine generator.

### [Solution to Problem]

According to the present invention, a method for monitoring a wind turbine generator configured to generate power by transmitting energy of wind from a rotor having a blade and a hub to which the blade is mounted to a generator via an energy transmission pathway arranged from the rotor to the generator, comprises:
a calculation step of calculating energy transmission efficiency in a monitoring object part located on the energy transmission pathway from input energy inputted to the monitoring object part and output energy outputted from the monitoring object part;
a temporal-change obtaining step of obtaining temporal change of the energy transmission efficiency from past energy transmission efficiency calculated in the calculation step;
an estimation step of estimating energy transmission efficiency in the future based on the temporal change; and
a determination step of determining maintenance timing based on the estimated energy transmission efficiency.

According to this monitoring method, energy transmission efficiency in the future is estimated based on the temporal change of the energy transmission efficiency in the monitoring object part and the maintenance timing is determined based on the estimated energy transmission efficiency. Thus, it is possible to set appropriate maintenance timing in accordance of the state of the monitoring object part. For instance, the energy transmission efficiency is estimated at scheduled maintenance timing that is set in advance, and if the estimated energy transmission efficiency is significantly below the efficiency that is set with normal deterioration in consideration, there is a possibility of occurrence of abnormality in operation of the wind turbine generator before the scheduled maintenance timing comes. Thus, the maintenance timing is moved up. As a result, it is possible to avoid unexpected shutdown of the wind turbine generator before the scheduled maintenance. On the other hand, if the estimated energy transmission efficiency is significantly higher than the efficiency that is set with normal deterioration in consideration, it is determined that the wind turbine generator can still operate normally even after the scheduled maintenance timing and thus, the scheduled maintenance is postponed. As a result, the maintenance is performed less frequently, thereby reducing the maintenance cost. Further, the monitoring object part located on the energy transmission pathway may be a blade, a speed increaser such as a gear transmission and a hydraulic transmission, a generator, etc.

In the above monitoring method, the monitoring object part may be a hydraulic transmission including a hydraulic pump and a hydraulic motor and located on the energy transmission pathway, and in the calculation step, the energy transmission efficiency may be calculated from the input energy to the hydraulic transmission and the output energy from the hydraulic transmission, the input energy being obtained from torque and rotation speed of a main shaft coupled to the rotor, the output energy being obtained from torque and rotation speed of an output shaft of the hydraulic motor.

By monitoring the hydraulic transmission as the monitoring object part, it is possible to know appropriate maintenance timing in correspondence with abnormalities that occur in the hydraulic transmission, such as an oil leak due to deterioration of a seal of the oil line and deterioration of a bearing of a rotary part.
Further, by calculating the input energy from the torque and the rotation speed of the main shaft and the output energy from the torque and the rotation speed of the output shaft of the hydraulic motor, it is possible to accurately detect the energy transmission efficiency in the hydraulic transmission.

In the above monitoring method, the monitoring object part may be the generator, and in the calculation step, the energy transmission efficiency may be calculated from the input energy to the generator and the output energy from the generator, the input energy being obtained from torque and rotation speed of an input shaft of generator, the output energy being obtained from power generated in the generator.

By monitoring the generator as the monitoring object part, it is possible to know appropriate maintenance timing in correspondence with abnormalities that occur in the generator, such as insulation deterioration and temperature rise of a generator winding and damage to a lightning arrestor of a generator panel or a generator bearing.
Further, by calculating the input energy from the torque and the rotation speed of the input shaft of the generator, and the output energy from the power generated by the generator, it is possible to accurately detect the energy transmission efficiency in the generator.

In the above monitoring method, the monitoring object part may be the rotor, and in the calculation step, the energy transmission efficiency may be calculated from the input energy to the rotor and the output energy from the rotor, the input energy being obtained from a wind direction and wind speed of the wind and a pitch angle of the blade, the output energy being obtained from torque and rotation speed of the main shaft.

By monitoring the rotor as the monitoring object part, it is possible to know appropriate maintenance timing in correspondence with abnormalities that occur in the rotor, such as deformation and damage of the blade and failure of a pitch drive system.
Further, by calculating the input energy from the direction and speed of the wind and the pitch angle of the blade and the output energy from the torque and rotation speed of the main shaft, it is possible to accurately detect the energy transmission efficiency in the rotor.

The above monitoring method may further comprise a cause determination step of determining a cause of decline in the energy transmission efficiency based on the temporal change.
The temporal change of the energy transmission efficiency is thought to vary depending on a cause of energy loss in the monitoring object part. Therefore, by analyzing the temporal change of the energy transmission efficiency, the cause of the decline in the energy transmission efficiency can be determined. As a result, it is possible to properly locate a maintenance part.

According to the present invention, a method for monitoring a wind turbine generator comprising and configured to generate power by transmitting energy of wind from a rotor having a blade and a hub to which the blade is mounted to a generator via an energy transmission pathway arranged from the rotor to the generator, comprises:
a calculation step of calculating energy transmission efficiency in a monitoring object part from input energy inputted to the monitoring object part and output energy outputted from the monitoring object part, the monitoring object being located on the energy transmission pathway; and
a decision step of deciding necessity for maintenance based on the energy transmission efficiency.

According to this monitoring method, the energy transmission efficiency in the monitoring object part is calculated and based on the calculated energy transmission efficiency, the necessity for maintenance is decided. As a result, it is possible to appropriately decide the necessity for performing maintenance in accordance with the state of the monitoring object part. For instance, if the energy transmission efficiency at the present point of time exceeds a range of the normal operation, it is determined that there is abnormality in the monitoring object part. Therefore, maintenance is performed promptly. As a result, the wind turbine generator is returned to such a state to deliver its original functions and it is possible to prevent unexpected shutdown of the wind turbine generator.

According to the present invention, a monitoring system for a wind turbine generator configured to generate power by transmitting energy of wind from a rotor having a blade and a hub to which the blade is mounted to a generator via an energy transmission pathway arranged from the rotor to the generator, comprises:
a calculation unit for calculating energy transmission efficiency in a monitoring object part located on the energy transmission pathway from input energy inputted to the monitoring object part and output energy outputted from the monitoring object part;
a temporal-change obtaining unit for obtaining temporal change of the energy transmission efficiency from past energy transmission efficiency calculated by the calculation unit;
an estimation unit for estimating energy transmission efficiency in the future based on the temporal change; and
a determination unit for determining maintenance timing based on the estimated energy transmission efficiency.

In the monitoring system, the energy transmission efficiency in the future is estimated based on the temporal change of the energy transmission efficiency in the monitoring object part, and based on the estimated energy transmission efficiency, the maintenance timing is determined. As a result, it is possible to set appropriate maintenance timing in accordance with the state of the monitoring object part.

### [Advantageous Effects of Invention]

According to the present invention, energy transmission efficiency in the future is estimated based on the temporal change of the energy transmission efficiency in the monitoring object part and the maintenance timing is determined based on the estimated energy transmission efficiency. Thus, it is possible to set appropriate maintenance timing in accordance of the state of the monitoring object part.
Further, the energy transmission efficiency in the monitoring object part is calculated and based on the calculated energy transmission efficiency, the necessity for maintenance is decided. Thus, it is possible to appropriately decide the necessity for performing maintenance in accordance with the state of the monitoring object part.

### [Brief Description of Drawings]

[FIG.1] FIG.1 is an illustration of a general structure of a wind turbine generator.
[FIG.2] FIG.2 is an illustration of a monitoring system and peripheral devices of the wind turbine generator according to a first embodiment of the present invention.
[FIG.3] FIG.3 is a cross-sectional view of a detailed configuration of a hydraulic pump.
[FIG.4A] FIG.4A is a cross-sectional view of the hydraulic pump taken along line A-A of FIG.3.
[FIG.4B] FIG.4B is a cross-sectional view of the hydraulic pump taken along line B-B of FIG.4A.
[FIG.5] FIG.5 is a graph showing temporal change of energy transmission efficiency.
[FIG.6] FIG.6 is a graph showing temporal change of energy transmission efficiency.
[FIG.7] FIG.7 is a flow chart illustrating one version of controlling the wind turbine generator according to the first embodiment of the present invention.
[FIG.8] FIG.8 is a schematic view of a configuration of a wind farm.
[FIG.9] FIG.9 is an illustration of the monitoring system and the peripheral devices of the wind turbine generator according to a second embodiment of the present invention.
[FIG.10] FIG.10 is an illustration of the monitoring system and the peripheral devices of the wind turbine generator according to a third embodiment of the present invention.

### [Description of Embodiments]

A preferred embodiment of the present invention will now be described in detail with reference to the accompanying drawings. It is intended, however, that unless particularly specified, dimensions, materials, shape, its relative positions and the like shall be interpreted as illustrative only and not limitative of the scope of the present invention.

### [FIRST EMBODIMENT]

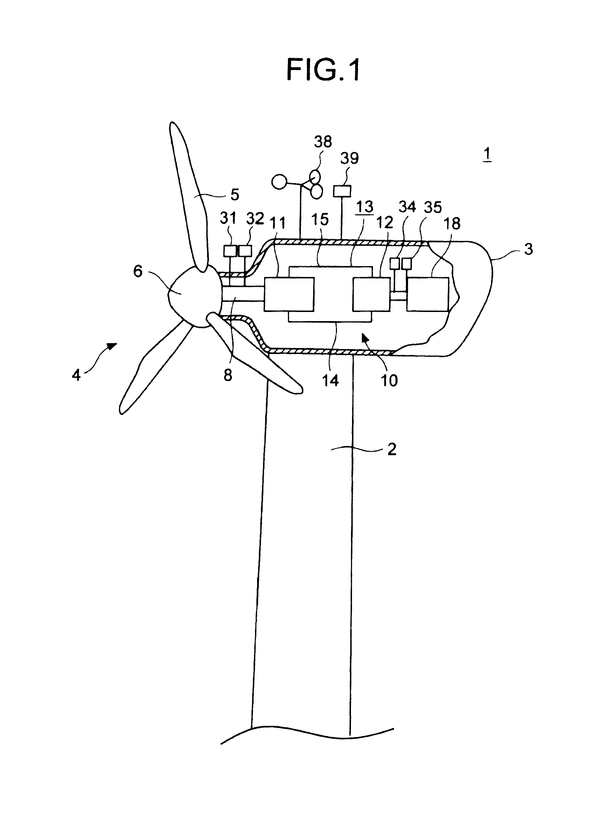

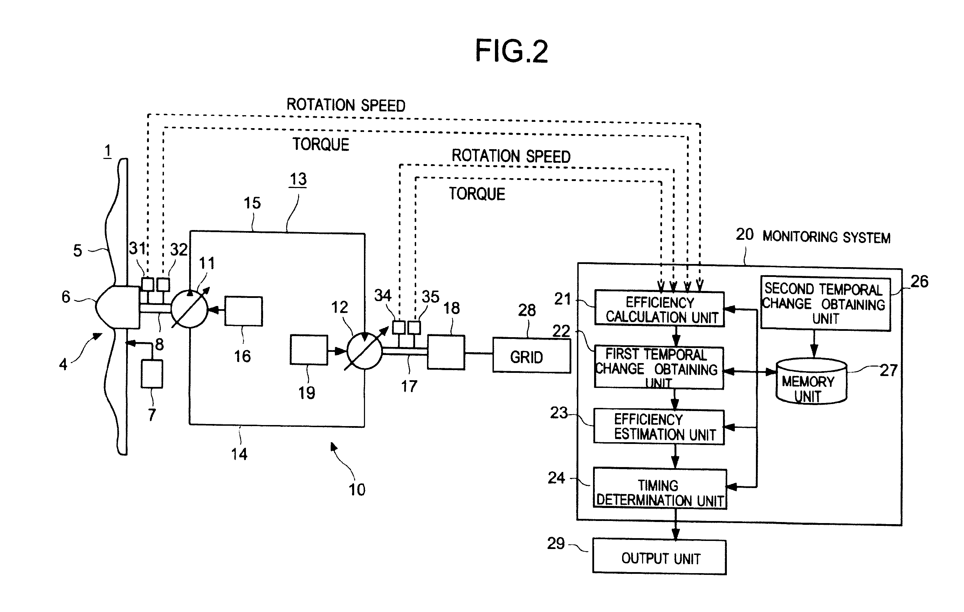

In reference to FIG.1 and FIG.2, a general structure of a wind turbine generator 1 is described. FIG.1 is an illustration of the general structure of the wind turbine generator 1. FIG.2 is an illustration of a monitoring system and peripheral devices of the wind turbine generator 1 according to a first embodiment of the present invention.

As illustrated in FIG.1, the wind turbine generator 1 is mainly provided with a tower 2 installed onshore or offshore (including general water such as a lake), a nacelle 3 arranged turnably relative to the tower 2, a rotor 4 supported rotatably by the nacelle 3, a main shaft 8 coupled to the rotor 4, a hydraulic transmission 10 for increasing rotation of the main shaft 8, a generator 18 to which the increased rotation is inputted from the hydraulic transmission 10, and a monitoring system 20 (see FIG.2) for determining maintenance timing of the wind turbine generator 1.

The rotor 4 is formed by a plurality of blades 5 and a hub 6 to which the blades 5 are mounted. FIG.1 illustrates, as one example, three blades 5 extending radially around the hub 6 and each of the blades 5 is mounted to the hub 6 coupled to the main shaft 8. As a result, the whole rotor 4 is rotated by power of the wind hitting the blades 5 and then the rotation is inputted to the hydraulic transmission 10 via the main shaft 8. As illustrated in FIG.2, a pitch actuator (a pitch drive system) 7 is attached to the blade 5 so as to adjust a pitch angle of the blade 5.

As illustrated in FIG.1 and FIG.2, the hydraulic transmission 10 includes a hydraulic pump 11 driven by the main shaft 8, a hydraulic motor 12 connected to the generator 18, and an oil line 13. The oil line 13 is formed by a high pressure oil line 15 and a low pressure oil line 14 that are provided between the hydraulic pump 11 and the hydraulic motor 12. Further, the hydraulic pump 11 is controlled by a pump controller 16 and a hydraulic motor 12 is controlled by a motor controller 19.
An outlet side of the hydraulic pump 11 is connected to an inlet side of the hydraulic motor 12 by the high pressure oil line 15. An inlet side of the hydraulic pump 11 is connected to an outlet side of the hydraulic motor 12 via the low pressure oil line 14. Operating oil discharged from the hydraulic pump 11 (high pressure oil) enters the hydraulic motor 12 via the high pressure oil line 15 and drives the hydraulic motor 12. The operating oil having performed work in the hydraulic motor 12 enters the hydraulic pump 11 via the low pressure oil line 14 and is pressurized in the hydraulic pump 11. The pressurized operating oil enters the hydraulic motor 12 again via the high pressure oil line 15. The hydraulic transmission 10 is described later in details.

For the purpose of detecting the operation state, the wind turbine generator 1 is provided with a plurality of sensors. In this embodiment, those sensors include a first rotation speed sensor 31 for detecting rotation speed of the main shaft 8, a first torque sensor 32 for detecting torque of the main shaft 8, a second rotation speed sensor 34 for detecting rotation speed of an output shaft 17 of the hydraulic motor 12, and a second torque sensor 35 for detecting torque of the output shaft 17. As the torque sensors 32, 35, a strain gauge may be used, for instance. Additionally, a wind speed sensor 38, a wind direction sensor 39, a pressure sensor for detecting pressure of the high pressure oil line 15 or the low pressure oil line 14, etc may be used.

The generator 18 is connected to the output shaft 17 of the hydraulic motor 12 of the hydraulic transmission 10 and also to grid 28. The generator 18 may be a synchronous generator, an induction generator, etc. which is publicly known. The generator 18 is configured to generate alternative current of approximately constant frequency when torque of approximately constant rotation speed is inputted from the hydraulic motor 12 and then the generated power is transmitted to the grid 28.

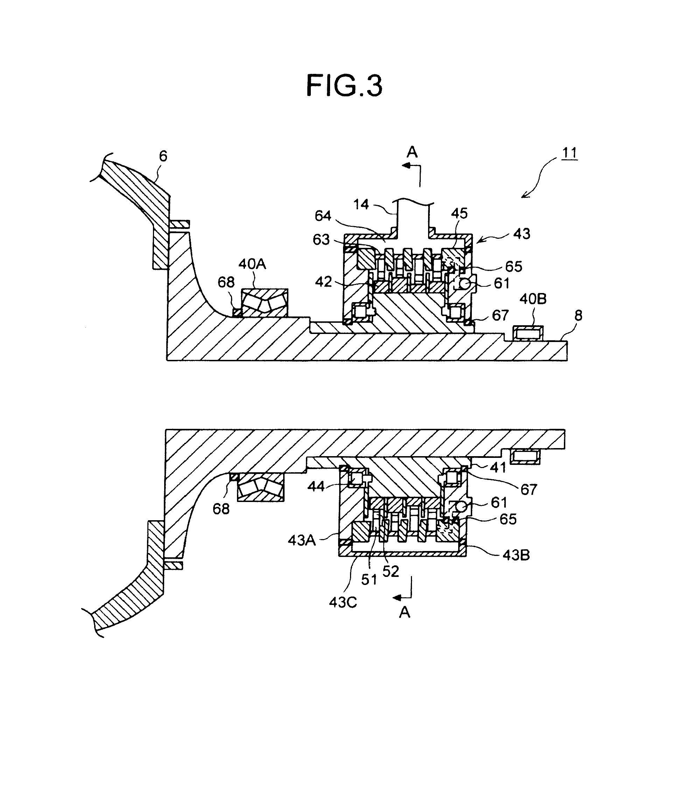

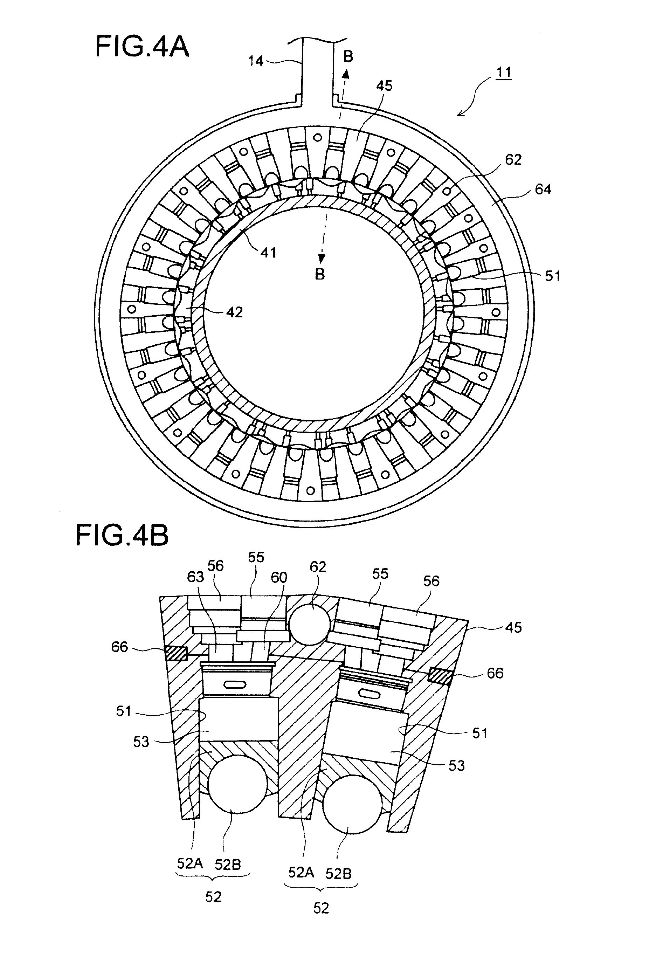

In reference to FIG.3 and FIG.4, a detailed configuration of the hydraulic pump 11 is described herein. FIG.3 is a cross-sectional view of the detailed configuration of a hydraulic pump. FIG.4A is a cross-sectional view of the hydraulic pump taken along line A-A of FIG.3. FIG.4B is a cross-sectional view of the hydraulic pump taken along line B-B of FIG.4A.

As illustrated in FIG.3, FIG.4A and FIG.4B, the hydraulic pump 11 is mounted to the main shaft 8 via a cam mount 41. The main shaft 8 is supported rotatably on the nacelle 3 side by shaft bearings 40A, 40B. In the example illustrated in FIG.3, the hydraulic pump 11 is arranged between the shaft bearings 40A, 40B. However, this is not limitative and the hydraulic pump 11 may be arranged on a side farther from the hub 6 than the shaft bearings 40A, 40B are.
To an outer periphery of the cam mount 41, a pump casing 43 is fixed via a pump bearing 44. The pump casing 43 is formed by a pair of end plates 43A, 43B and a cylindrical case 43C provided between the end plates 43A, 43B. The pump casing 43 is configured to cover cylinders 51, pistons 52, a high pressure manifold 61, a low pressure manifold 64, the high pressure valves 55, the low pressure valves 56 (see FIG.4) and a cam 42. The pump casing 43 prevents the operating oil from leaking to outside. The cam 42 may be a ring cam having wave-shaped lobes with depressions and projections alternately formed around the main shaft 8.

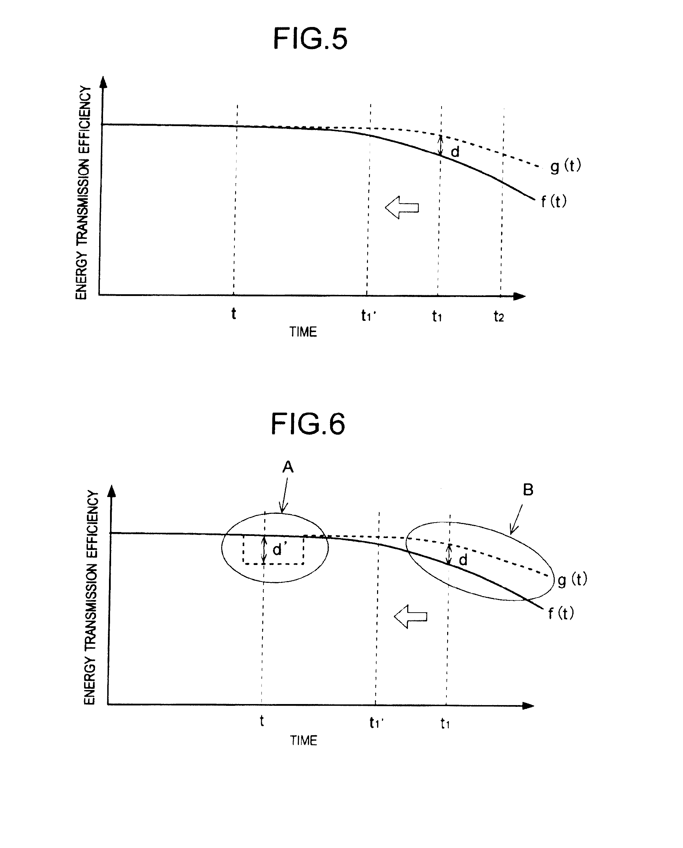

The hydraulic pump 11 may include a plurality of modules each of which is formed by a cylinder block 45 having at least one cylinder 51, a piston 52 provided for each of the at least one cylinder 51 of the cylinder block 45, the high pressure manifold 61, the low pressure manifold 64, the high pressure valve 55 and the low pressure valve 56.
Inside the cylinder 51, a working chamber 53 surrounded by the cylinder 51 and the piston 52 is formed.
From the perspective of operating the piston 52 smoothly along the cam profile of the cam 42, the piston 52 may be formed by a piston body 52A slidable in the cylinder 51 and a piston roller 52B or a piston shoe engageable with the cam profile of the cam 42. FIG.5 illustrates the case where the piston 52 is formed by the piston body 52A and the piston roller 52B.

The working chamber 53 is configured so that the volume is variable by reciprocating the piston 52 within the cylinder 51. With this working chamber 53, a high pressure oil path 60 and a low pressure oil path 63 are in communication. The high pressure oil path 60 is opened and closed by the high pressure valve 55, whereas the low pressure oil line 53 is opened and closed by the low pressure valve 56.

There is a plurality of the high pressure oil paths 60 and some of these high pressure oil paths 60 communicate with one of a plurality of high pressure collecting paths 62 formed in the end plate 43B. The high pressure manifold 61 is connected to the high pressure oil line 15 illustrated in FIG.2. Therefore, the high pressure oil is discharged from the working chambers 53 through the high pressure oil paths 60, the high pressure collecting path 62 and a high pressure manifold 61 to the high pressure oil line 15 in this order.

A plurality of the low pressure oil paths 63 are in communication with the low pressure manifold (a ring tank) 64 formed by an outer periphery of the cylinder block 45 and the cylindrical casing 43. The low pressure manifold 64 is connected to the low pressure oil line 14. Therefore, the low pressure oil is introduced from the low pressure oil line 14 through the low pressure manifold 64, the low pressure oil paths 63 to the working chambers 53 in this order.

In the hydraulic pump 11 having the above configuration, the cam 42 rotates with the main shaft 8. This causes the piston 52 to move upward and downward periodically to repeat a pump stroke where the piston 52 moves from a bottom dead center to a top dead center and an intake stroke where the piston 52 moves from the top dead center to the bottom dead center. During the pump stroke, the high pressure valve 55 is opened and the low pressure valve 56 is closed so as to supply the high pressure oil in the working chamber 53 to the high pressure oil line 15. In contrast, during the intake stroke, the high pressure valve 55 is closed and the low pressure valve 56 is opened so as to supply the low pressure oil in the working chamber 53 to the low pressure oil line 14.

This hydraulic pump 11 is capable of changing a state of each working chamber 53 between an active state and an idle state by opening and closing the high pressure valve 55 and the low pressure valve 56 by means of the pump controller 16 (see FIG.2). When the working chamber 53 is in the active state, during the intake stroke the high pressure valve 55 is closed and the low pressure valve 56 is opened so as to feed the operating oil from the low pressure oil line 14 into the working chamber 53 and during the pump stroke the high pressure valve 55 is opened and the low pressure valve 56 is closed so as to feed the pressurized operating oil from the working chamber 53 to high pressure oil line 15. In contrast, when the working chamber 53 is in the idle state, during both the intake stroke and the pump stroke, the high pressure valve 55 is kept closed and the low pressure valve 56 is kept open so as to circulate the operating oil between the working chamber 53 and the low pressure oil line 14. In other words, the operating oil is not sent to the high pressure oil line 15. By controlling opening and closing of the high pressure valve 55 and the low pressure valve 56 in the above manner, the pump controller 16 controls an operation state of the hydraulic pump 11 (the idle state or the active state). More specifically, by adjusting the number of the working chambers that are in the active state, the energy transmission efficiency in the hydraulic transmission 10 can be adjusted.

The energy transmission efficiency is adjustable by changing displacement of the hydraulic transmission in the above manner. Besides this situation where the energy transmission efficiency is adjusted, the energy efficiency declines when the high pressure operating oil flowing in the high pressure oil line 15 leaks. Thus, a seal is provided in a place where the high pressure oil might leak. For instance, as illustrated in FIG.3, a high pressure seal 65 is provided around a connection part between the high pressure collecting path 62 formed in the cylinder block 45 and the high pressure manifold 61 formed in the end plate 43B, so as to prevent leak of the high pressure oil from this connection part. Further, as shown in FIG.4B, a valve seal 66 is provided in the periphery of the valves 55, 56 so as to prevent leaking of the high pressure oil from the high pressure oil path 60 and of the low pressure oil from the low pressure oil path 63. Of course, a seal may be provided for the purpose of preventing leak of the low pressure oil line. For instance, the low pressure oil is supplied as lubricating oil to a cam chamber where the cam 42 is arranged in some cases and in those cases, an inner seal 67 may be provided between the cam chamber and the cam mount 41. Further, the low pressure oil is supplied as lubricating oil to the shaft bearings 40A, 40B in some cases and in those cases, a shaft seal 68 may be provided near an oil inlet of a bearing housing which covers the shaft bearing 40A, 40B.

However, age-related deterioration of these seals is unavoidable. Scheduled maintenance is normally set by considering deterioration speed of the case where the seal is used without trouble. More specifically, the seal is replaced during the scheduled maintenance, before output of the generator declines significantly due to leak of the high pressure oil caused by deterioration of the seal. However, when ambient temperature of the seal is significantly higher than a setting value or the seal is broken, leak of the high pressure oil progresses, causing unexpected shutdown of the wind turbine generator 1 or drastic decline in the output of the generator.
Besides the failure of the seal, if there are abnormalities such as failure and excessive deterioration in the parts that affect the energy transmission efficiency of the wind turbine generator 1, the energy transmission efficiency declines significantly compared to the normal. The abnormalities include excessive deterioration due to uneven loading to the pump bearing 44.

In this case, maintenance is performed to replace or repair the component before next scheduled maintenance. Therefore, in this embodiment, the monitoring system 20 is provided to detect the state of the monitoring object part existing on the energy transmission pathway among the components of the wind turbine generator 1 and to determine appropriate maintenance timing based on the detected state of the monitoring object part. The energy transmission pathway is a pathway arranged from the rotor 4 to the generator 18. The monitoring object part includes, for instance, the rotor 4, the hydraulic transmission 10, the generator 18 or the like. In this embodiment, the hydraulic transmission 10 is described as the monitoring object part.

The monitoring system 20 according to this embodiment is mainly provided with an efficiency calculation unit 21, a first temporal change obtaining unit 22, an efficiency estimation unit 23, a timing determination unit 24, a second temporal change obtaining unit 26 and a memory unit 27.
Further, as a detailed configuration of the monitoring system 20, operation units except the memory unit 27 (the efficiency calculation unit 21, the first temporal change obtaining unit 22, the efficiency estimation unit 23, the timing determination unit 24, the second temporal change obtaining unit 26, etc.) are, for instance, formed by CPU (not shown), RAM and a computer-readable record medium. A series of processes for achieving functions that are described later are stored in a record medium or the like in a form of a program. This program is retrieved by CPU to RAM, etc. and information processing and arithmetic processing are performed to achieve the functions that are described later. Further, the memory unit 27 of the monitoring system 20 is configured to store a variety of data based on commands of each operation unit. The memory unit 27 is formed by RAM, a computer-readable record medium, etc.

The efficiency calculation unit 21 is configured to calculate the energy transmission efficiency in the monitoring object part from input energy and output energy. The input energy is inputted from the monitoring object part existing on the energy transmission pathway and the output energy is outputted from the monitoring object part. In this embodiment, for instance, the input energy to the hydraulic transmission 10 is calculated by multiplying rotation speed of the main shaft 8 detected by the first rotation speed sensor 31 by torque of the main shaft 8 detected by the first torque sensor 32, and the output energy from the hydraulic transmission 10 is calculated by multiplying rotation speed of the output shaft 17 of the hydraulic motor 12 detected by the second rotation speed sensor 34 by torque of the output shaft 17 of the hydraulic motor 12 detected by the second torque sensor 35. Then, the output energy is divided by the input energy to calculate the energy transmission efficiency.

The first temporal change obtaining unit 22 obtains temporal change of the energy transmission efficiency from past energy transmission efficiency calculated by the efficiency calculation unit 21. The energy transmission efficiency that is obtained in this manner is hereinafter described as achieved efficiency. More specifically, the achieved efficiencies at a plurality of points of time in the past are calculated and stored in the memory unit and based on the achieved efficiencies, the temporal change is obtained. In this process, the temporal change of the achieved efficiency may be obtained, for instance, in a form of function f(t) of FIG.5. The function f(t) that fits the achieved efficiencies at the points of time in the past may be obtained, for instance, using a known method such as by obtaining approximate function based on least-square approach, etc. The achieved efficiency changes due to the change in displacement of the hydraulic pump 11 as well and thus, either conversion into achieved efficiency at constant displacement is performed even in the case where the displacement changes, or the displacement is used as a parameter. Further, FIG.5 is a graph showing the temporal change of the energy transmission efficiency (the achieved efficiency).

The efficiency estimation unit 23 is configured to estimate future achieved efficiency based on the temporal change of the achieved efficiency obtained by the first temporal change obtaining unit 22. For instance, using the function f(t) obtained by the first temporal change obtaining unit 22, the future achieved efficiency at maintenance timing t1 of next scheduled maintenance is calculated.

The second temporal change obtaining unit 26 obtains temporal change of the energy transmission efficiency of the case where there is no abnormality such as failure and excessive deterioration in the hydraulic transmission 10. The energy transmission efficiency that is obtained in this manner is hereinafter described as expected efficiency. In this case, the temporal change of the expected efficiency may be obtained, for instance, in a form of function g(t) of FIG.5. As an example, FIG.5 shows the expected efficiency at the constant displacement and the function g(t) is obtained by considering deterioration of the seals, bearings, etc caused by use only, supposing that there is no excessive damage or deterioration in the hydraulic transmission 10. More specifically, the function g(t) is obtained by considering the deterioration speed of the deteriorating component such as seals and bearings, through simulation, calculation, tests, etc.

Stored in the memory unit 27 are the past achieved efficiency calculated by the efficiency calculation unit 21, the temporal change of the achieved efficiency obtained by the first temporal change obtaining unit 22, the temporal change of the expected efficiency obtained by the second temporal change obtaining unit 26, a threshold value M, etc. Herein, the threshold value M is used in the timing determination unit 24 described later. The threshold value M is stored beforehand in the memory unit 27. Further, a scheduled-maintenance plan which is set beforehand may be stored in the memory unit 27.

The timing determination unit 24 determines the maintenance timing based on the achieved efficiency estimated by the efficiency estimation unit 23, the expected efficiency and the threshold value M. For instance, as illustrated in FIG.5, difference d between the expected efficiency g(t₁) and the achieved efficiency f(t₁) at the next maintenance timing t₁ is compared with the threshold value M. If the difference d is not greater than the threshold value M, the achieved efficiency is not so far from the expected efficiency and thus it is determined that there is no abnormality in the hydraulic transmission 10. Therefore, the scheduled maintenance is performed as planned. On the other hand, if the difference d exceeds the threshold value M, there is possibility that there are abnormalities in the hydraulic transmission 10. Therefore, the scheduled maintenance timing t₁ is moved forward to timing t₁' and maintenance is performed at the moved maintenance timing t₁'. In this step, the moved maintenance timing t₁' may be set in accordance with a level and type of expected abnormalities so that maintenance is surely performed before this abnormality causes unexpected shutdown of the wind turbine 1. Further, in this step, the moved maintenance timing t₁' may be set appropriately by considering loss of income of sales from electric power due to reduction in power generation based on the efficiency decline in the hydraulic transmission 10 and increased maintenance cost due to frequent maintenance. The maintenance timing that is set in this manner is outputted from an output unit 29.

Alternatively, in the timing determination unit 24, difference between the expected efficiency g(t₁) and the achieved efficiency f(t₁) at the scheduled maintenance timing t₁ may be compared with the threshold value M. If the difference is not greater than the threshold value M, it is estimated that the achieved efficiency of the hydraulic transmission 10 can be maintained along the expected efficiency at first scheduled maintenance timing which is the first one from the present point of time. Therefore, it may be set to perform second scheduled maintenance without performing the first scheduled maintenance. Then, the difference between the expected efficiency g(t₂) and the achieved efficiency f(t₂) at the second scheduled maintenance timing t₂ is compared with the threshold value M. If the difference exceeds the threshold value M, either the maintenance is performed at the second scheduled timing t₂ or the second scheduled timing t₂ is moved forward to perform maintenance at timing between the first scheduled maintenance timing t₁ and the second scheduled maintenance timing t₂.

Further, as illustrated in FIG.6, in the timing determination unit 24, difference d' between the achieved efficiency g(t) and the expected efficiency (t) at the present point of time t is compared with the threshold value M. If the difference d' exceeds the threshold value M, it may be decided that there is necessity for maintenance aside from the scheduled maintenance. FIG.6 is a graph showing temporal change of different energy transmission efficiency. As illustrated in FIG.6, if the difference d' between the achieved efficiency g(t) and the expected efficiency (t) has already exceeded the threshold value at the present point, it is determined that abnormality is progressing or there is serious abnormality. Therefore, maintenance is performed promptly. As a result, the wind turbine generator 1 is returned to such a state to deliver the original functions and it is possible to prevent unexpected shutdown of the wind turbine generator 1.

Furthermore, the timing determination unit 24 may determine a cause of decline in the achieved efficiency based on the temporal change of the achieved efficiency. It is thought that the temporal change of the achieved efficiency varies depending on a cause of energy loss in the hydraulic transmission 10. Therefore, by analyzing the temporal change of the achieved efficiency, the cause of the decline in the achieved efficiency can be determined. Therefore, it is possible to properly locate a maintenance part that requires maintenance. For instance, when the achieved efficiency suddenly declines as illustrated in section A of FIG.6, failure of the valve of the hydraulic pump 11 is considered to be a cause of the efficiency decline. Therefore, the valve is identified as a maintenance object part to perform maintenance on. In this case, by replacing or repairing the valve, it is highly possible that performance of the hydraulic transmission 10 is recovered. In contrast, when the achieved efficiency gradually declines as illustrated in section B of FIG.6, leak of the high pressure oil due to deterioration of the seal such as the high pressure seal 65 and the valve seal 66 of the hydraulic pump 11 (see FIG.3, FIG.4B) is considered to be a cause of the efficiency decline. Therefore, the high pressure oil seal is identified as the maintenance object part. In this case, by replacing the seal, it is highly possible that performance of the hydraulic transmission 10 is recovered.

Further, in the case where the high pressure valve 55 or the low pressure valve 56 of the hydraulic pump 11 is an electromagnetic valve, failure of the valve may be detected by an electrical signal from the pump controller 16. More specifically, the high pressure valve 55 or the low pressure valve 56 (see FIG.4B) are controlled by the pump controller 16 by controlling opening and closing of the valve in accordance with opening-closing command. Thus, the failure of the valve is detectable based on behavior of voltage. For instance, when it is slow for the voltage of the valve to respond to the opening-closing command, when the voltage of the valve does not reach a command value, etc., failure of the valve may be determined. As described above, in combination with the valve failure detection using the electrical signal from the pump controller 16, the valve failure can be positively determined from the temporal change of the achieved efficiency. As a result, it is easy to determine a cause of other abnormalities as well.

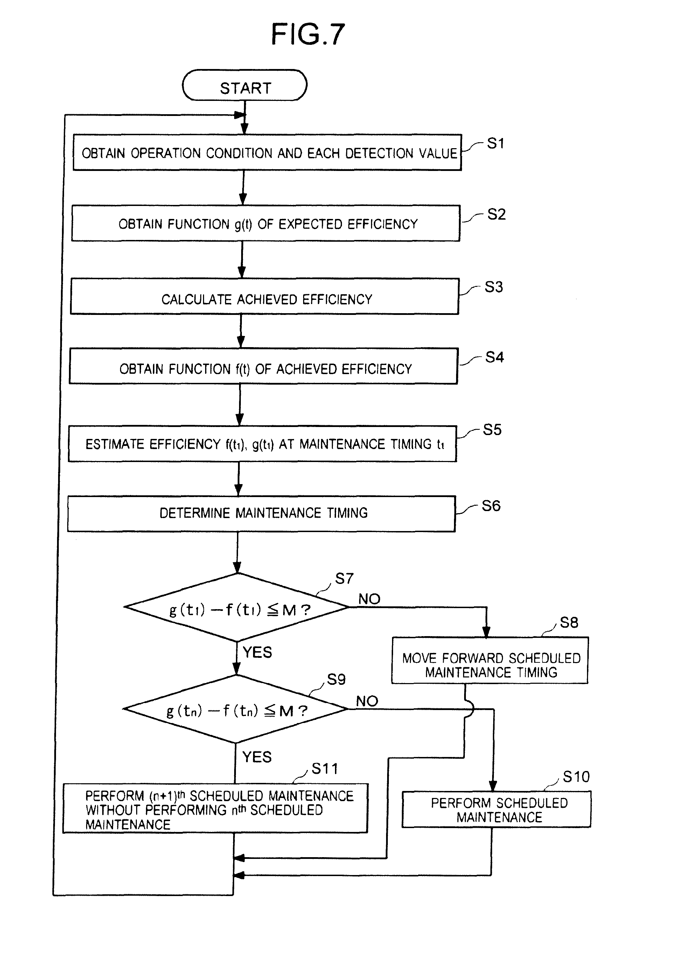

In reference to a flow chart of FIG.7, the monitoring method by means of a monitoring system for the above wind turbine generator 1 is explained.
During operation of the wind turbine generator 1, detection values are inputted to the monitoring system 20, such as rotation speed of the main shaft 8 detected by the first rotation speed sensor 31, torque of the main shaft 8 detected by the first torque sensor 32, rotation speed of the output shaft 17 of the hydraulic motor detected by the second rotation speed sensor 34, and torque of the output shaft 17 detected by the second torque sensor 35. Operation conditions such as displacement of the hydraulic pump 11 (valve usage) are also inputted to the monitoring system 20 from the pump controller 16 (step S1).

The second temporal change obtaining unit 26 of the monitoring system 20 obtains function g(t) indicating temporal change of the expected efficiency of the case where it is assumed there is no abnormality in the hydraulic transmission 10, based on operation condition such as displacement of the hydraulic pump 11 (step S2).
The efficiency calculation unit 21 of the monitoring system 20 calculates the input energy to the hydraulic transmission 10 by multiplying the rotation speed of the main shaft 8 by the torque of the main shaft 8 and also calculates the output energy from the hydraulic transmission 10 by multiplying the rotation speed of the output shaft 17 by the torque of the output shaft 17. Then, the output energy is divided by the input energy to calculate the achieved efficiency of the hydraulic transmission 10 (step S3). The calculated achieved efficiency is matched with time and stored in the memory unit 27. Once the achieved efficiencies are obtained at a plurality of points of time, function f(t) indicating the temporal change of the achieved efficiency is obtained by the temporal change obtaining unit 21 using the obtained achieved efficiencies (step S4).

Next, the efficiency estimation unit 23 extracts the next scheduled maintenance timing t₁ from the scheduled-maintenance plan stored in the memory unit 27 and then estimates achieved efficiency f(t₁) and expected efficiency g(t₁) at the scheduled maintenance timing from function f(t) of the achieved efficiency and function g(t) of the expected efficiency (step S5).
Further, the maintenance timing (t₁) is determined by the timing determination unit 24 from the achieved efficiency f(t₁), the expected efficiency g(t₁), and the threshold value M stored in the memory unit 27 (step S6). More specifically, in step S7, difference d between the expected efficiency g(t₁) and the achieved efficiency f(t₁) is compared with the threshold value M. If the difference d is greater than the threshold value M, the scheduled maintenance timing t₁ is moved forward and maintenance is performed at the moved maintenance timing (step S8). On the other hand, if the difference d is not greater than the threshold value M, the scheduled maintenance is performed.

Alternatively or additionally, in step S9, difference d between expected efficiency g(tₙ) and the achieved efficiency f(tₙ) at n^{th} scheduled maintenance timing tₙ is compared with the threshold value M. If the difference d is greater than the threshold value M, the scheduled maintenance is performed (step S10). On the other hand, if the difference d is not greater than the threshold value M, (n+1)^{th} scheduled maintenance is performed without performing the n^{th} scheduled maintenance (step S11).

As described in this embodiment, based on the temporal change of the achieved efficiency in the hydraulic transmission 10 which is the monitoring object part, the achieved efficiency in the future is estimated and based on the estimated achieved efficiency, the maintenance timing is determined. Therefore, it is possible to set appropriate maintenance timing in accordance with the state of the monitoring object part.
Further, by monitoring the hydraulic transmission 10 as the monitoring object part, it is possible to know appropriate maintenance timing in correspondence with abnormalities that occur in the hydraulic transmission 10, such as oil leak due to deterioration of a seal of the oil line 13 and deterioration of a bearing of a rotary part.
Furthermore, by calculating the input energy from the torque and the rotation speed of the main shaft 8 and the output energy from the torque and the rotation speed of the output shaft 17 of the hydraulic motor 12, it is possible to accurately detect the achieved efficiency in the hydraulic transmission 10.

Moreover, in the first embodiment described above, the monitoring system 20 may be individually provided for the wind turbine, or provided in a remote monitoring system for monitoring the wind farm having a plurality of the wind turbine generators 1 in an integrated manner.

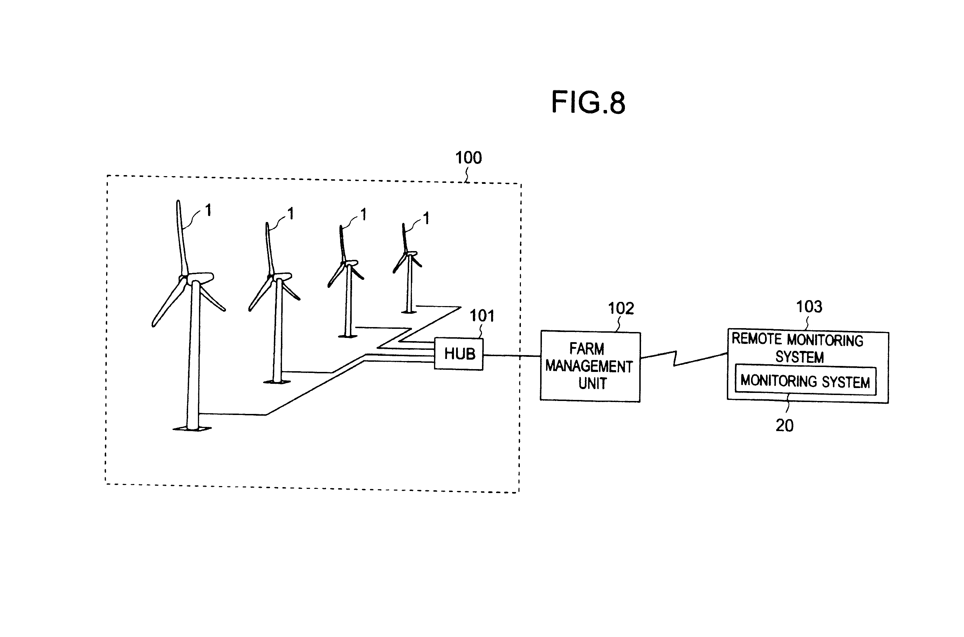

FIG.8 illustrates the case where the monitoring system 20 is provided in the remote monitoring system. As illustrated in FIG.8, a plurality of the wind turbine generators 1 are installed in a standing manner in the wind farm 100. The power generated in these wind turbine generators 1 is sent to the grid via a booster transformer and a grid connection panel.

Control lines extending from each wind turbine generator 1 are collected to a hub 101 and the hub 101 is connected to a farm management unit 102 installed on site via a communication cable. Further, the farm management unit 102 is connected via a communication line to the remote monitoring system 103 installed in a remote location. The farm management unit 102, the remote monitoring system 103 are both formed by a computer having CPU, ROM, RAM, memory, a communication interface, etc. and are configured to mainly operate and monitor the wind turbine generator 1. The above monitoring system 20 may be built into the remote monitoring system 103. As a result, it is possible to monitor the operation state of a plurality of wind turbine generators 1 in an integrated manner and also to set appropriate maintenance timing even in a remote location.

### (SECOND EMBODIMENT)

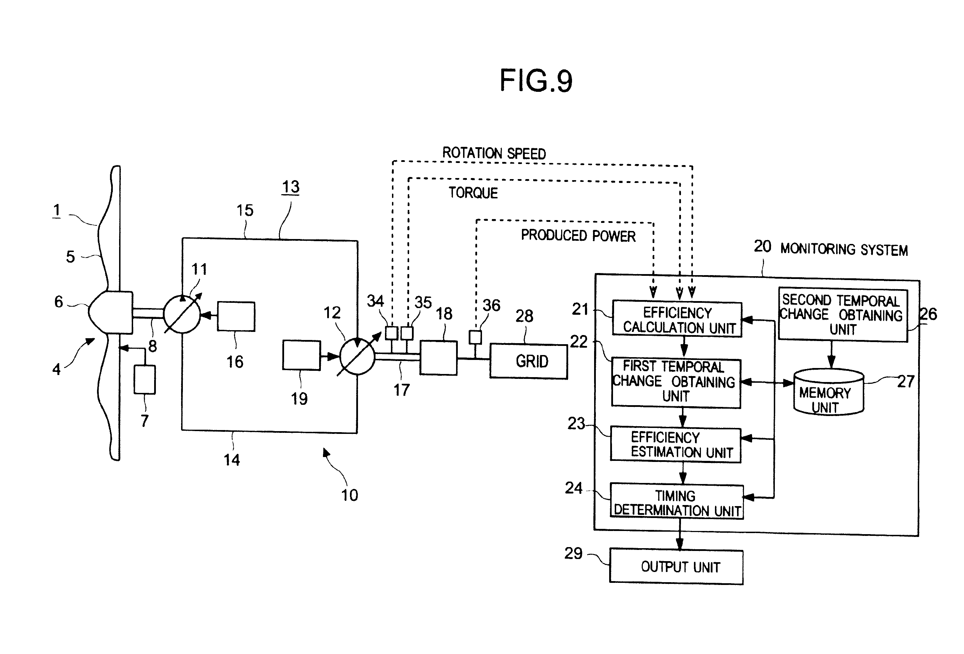

In reference to FIG.9, the monitoring method and the monitoring system for the wind turbine generator according to a second embodiment is described. In this embodiment, the configuration of the wind turbine generator 1 is substantially the same as the wind turbine generator 1 of the first embodiment except that the generator is the monitoring object part. Therefore, in this embodiment, components already described in the first embodiment are denoted by the same reference numerals, and thus detailed description thereof will be hereinafter omitted and mainly components different from the first embodiment are explained.

As illustrated in FIG.9, the monitoring system 20 according to this embodiment is mainly provided with the efficiency calculation unit 21, the first temporal change obtaining unit 22, the efficiency estimation unit 23, the timing determination unit 24, the second temporal change obtaining unit 26 and the memory unit 27. Further, as sensors for detecting the operation state of the wind turbine generator 1, the second rotation speed sensor 34 for detecting rotation speed of an output shaft 17 of the hydraulic motor 12, the second torque sensor 35 for detecting torque of the output shaft 17, and an instrument transformer (CT · VT) 36 for detecting power generated by the generator 18 are provided. The output shaft 17 of the hydraulic motor 12 is practically the same as the input shaft of the generator 18.

In this embodiment, the efficiency calculation unit 21 calculates achieved efficiency (energy transmission efficiency) from input energy inputted to the generator 18 and output energy outputted from the generator 18. For instance, the input energy to the generator 18 is calculated by multiplying rotation speed of the output shaft 17 of the hydraulic motor 12 detected by the second rotation speed sensor 34 by torque of the output shaft 17 detected by the second torque sensor 35, and the output energy from the generator 18 is calculated from the power calculated from the current and voltage measured by the instrument transformer 36.

The first temporal change obtaining unit 22 obtains temporal change of the achieved efficiency in the generator 18 from the past achieved efficiency calculated by the efficiency calculation unit 21.
Further, the second temporal change obtaining unit 26 obtains temporal change of expected efficiency (energy transmission efficiency) of the case where there is no abnormality such as failure and excessive deterioration of the generator 18. In this case, the expected efficiency may be obtained with respect to the rotation speed of the input shaft of the generator 18 (i.e. the output shaft 17 of the hydraulic motor 12). More specifically, the expected efficiency with respect to the rotation speed of the input shaft may be calculated by considering all types of loss in the generator 18 in a healthy state obtained by analysis, experiments, etc.
The configurations of the efficiency estimation unit 23, the timing determination unit 24 and the memory unit 27 are substantially the same as described in the first embodiment and thus are not explained further.

The monitoring method by the above monitoring system 20 is explained.
First, the second temporal change obtaining unit 26 of the monitoring system 20 obtains temporal change of expected efficiency of the case where there is no abnormality such as failure and excessive deterioration in the generator 18.

Meanwhile, the efficiency calculation unit 21 of the monitoring system 20 calculates the achieved efficiency by dividing the output energy by the input energy. The input energy to the generator 18 is calculated by multiplying the rotation speed of the output shaft 17 of the hydraulic motor 12 by the torque of the output shaft 17 and the output energy is calculated from the generator 18 from the power generated by the generator 18. Further, the temporal change of the achieved efficiency of the generator 18 is calculated using the achieved efficiency by the first temporal change obtaining unit 22.

Next, the efficiency estimation unit 23 estimates achieved efficiency f(t₁) and expected efficiency g(t₁) at the next scheduled maintenance timing t₁.
Then, the timing determination unit 24 determines the maintenance timing by comparing the difference d between the achieved efficiency f(t₁) and the expected efficiency g(t₁) with the threshold value M stored in the memory unit 27.
Alternatively or additionally, difference d between expected efficiency g(tₙ) and the achieved efficiency f(tₙ) at n^{th} scheduled maintenance timing tₙ is compared with the threshold value M so as to determine the maintenance timing.

As described above, in this embodiment, by monitoring the generator 18 as the monitoring object part, it is possible to know appropriate maintenance timing in correspondence with abnormalities that occur in the generator 18, such as insulation deterioration and temperature rise of a generator winding and damage to a lightning arrestor of a generator panel or a generator bearing.
Further, by calculating the input energy from the torque and the rotation speed of the input shaft of the generator 18, i.e. the output shaft 17 of the hydraulic motor 12 and the output energy from the power generated by the generator 18, it is possible to accurately detect the achieved efficiency in the generator 18.

### (THIRD EMBODIMENT)

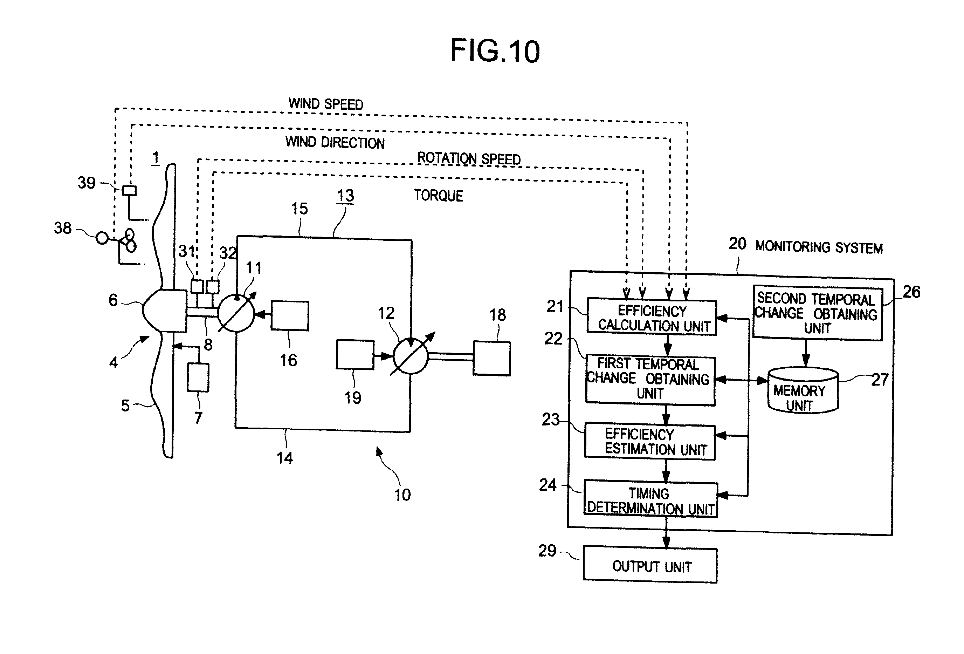

In reference to FIG.10, the monitoring method and the monitoring system for the wind turbine generator according to a third embodiment is described. In this embodiment, the configuration of the wind turbine generator 1 is substantially the same as the wind turbine generator 1 of the first embodiment except that the rotor 4 is the monitoring object part. Therefore, in this embodiment, components already described in the first embodiment are denoted by the same reference numerals, and thus detailed description thereof will be hereinafter omitted and mainly components different from the first embodiment are explained.

As illustrated in FIG.10, the monitoring system 20 according to this embodiment is mainly provided with the efficiency calculation unit 21, the first temporal change obtaining unit 22, the efficiency estimation unit 23, the timing determination unit 24, the second temporal change obtaining unit 26 and the memory unit 27. Further, as sensors for detecting the operation state of the wind turbine generator 1, a wind speed sensor 38 for detecting wind speed, a wind direction sensor 39 for detecting direction of the wind, the first rotation speed sensor 31 for detecting rotation speed of the main shaft 8, and the first torque sensor 32 for detecting torque of the main shaft 8 are provided.

In this embodiment, the efficiency calculation unit 21 calculates achieved efficiency (energy transmission efficiency) from input energy inputted to the rotor 4 and output energy outputted from the rotor 4. For instance, the input energy to the rotor 4 is calculated from a wind direction detected by the wind direction sensor 39, wind speed detected by the wind speed sensor 38 and a pitch angle set by the pitch drive system 7. The output energy outputted from the rotor 4 is calculated by multiplying rotation speed of the main shaft 8 detected by the first rotation speed sensor 31 by torque of the rotation shaft 8 detected by the first torque sensor 32.

The first temporal change obtaining unit 22 obtains temporal change of the achieved efficiency in the rotor 4 from past achieved efficiency calculated by the efficiency calculation unit 21.
Further, the second temporal change obtaining unit 26 obtains temporal change of expected efficiency (energy transmission efficiency) of the case where there is no abnormality such as deformation, damage and excessive deterioration of the blade 5.
The configurations of the efficiency estimation unit 23, the timing determination unit 24 and the memory unit 27 are substantially the same as described in the first embodiment and thus are not explained further.

The monitoring method by the above monitoring system 20 is explained.
First, the second temporal change obtaining unit 26 of the monitoring system 20 obtains temporal change of expected efficiency of the case where there is no abnormality in the rotor 4.
Meanwhile, the efficiency calculation unit 21 calculates the input energy to the rotor 4 from the wind speed, the wind direction and the pitch angle of the blade, and calculates the output energy from the rotor 4 from the rotation speed and torque of the main shaft 8. Further, the efficiency calculation unit 21 calculates the achieved efficiency by dividing the output energy by the input energy. Then, the first temporal change obtaining unit 22 obtains the temporal change of the achieved efficiency of the rotor 4 using the achieved efficiency.

Next, the efficiency estimation unit 23 estimates achieved efficiency f(t₁) and expected efficiency g(t₁) at the next scheduled maintenance timing t₁.
Then, the timing determination unit 24 determines the maintenance timing by comparing the difference d between the achieved efficiency f(t₁) and the expected efficiency g(t₁) with the threshold value M stored in the memory unit 27.
Alternatively or additionally, difference d between the expected efficiency g(tₙ) and the achieved efficiency f(tₙ) at n^{th} scheduled maintenance timing tₙ is compared with the threshold value M so as to determine the maintenance timing.

As described above, in this embodiment, by monitoring the rotor 4 as the monitoring object part, it is possible to know appropriate maintenance timing in correspondence with abnormalities that occur in the rotor 4, such as deformation and damage of the blade 5 and failure of the pitch drive system.
Further, by calculating the input energy from the direction and speed of the wind and the pitch angle of the blade and the output energy from the torque and rotation speed of the main shaft 8, it is possible to accurately detect the achieved efficiency in the rotor 4.

While the embodiments of the present invention have been described, it is obvious to those skilled in the art that the first to third embodiments may be applied in any combination and various changes may be made without departing from the scope of the invention.

For instance, the monitoring method and the monitoring system for the wind turbine generator according to first to third embodiments, is applied to the wind turbine generator 1 having the hydraulic transmission 10. However this is not limitative and the monitoring method and the monitoring system may be applied to the wind turbine generator having a gear transmission. For instance, in the case of applying the first embodiment illustrated in FIG.2 to the wind turbine generator with the gear transmission, input energy to the gear transmission is calculated from the torque and rotation speed of the main shaft 8 and the output energy is calculated from torque and rotations peed of the output shaft 17 of the gear transmission coupled to the generator 18. Then, based on this input energy and output energy, the achieved efficiency is calculated, and by comparing the achieved efficiency with the threshold value, the maintenance timing is determined. Similarly to this, the maintenance timing can be determined in the second and third embodiments as well.

## Claims

1. A method for monitoring a wind turbine generator (1) configured to generate power by transmitting energy of wind from a rotor (4) having a blade (5) and a hub (6) to which the blade (5) is mounted to a generator (18) via an energy transmission pathway arranged from the rotor (4) to the generator (18), the method **characterized by**:
a calculation step of calculating energy transmission efficiency in a monitoring object part located on the energy transmission pathway from input energy inputted to the monitoring object part and output energy outputted from the monitoring object part;
a temporal-change obtaining step of obtaining temporal change of the energy transmission efficiency from past energy transmission efficiency calculated in the calculation step;
an estimation step of estimating energy transmission efficiency in the future based on the temporal change; and
a determination step of determining maintenance timing based on the estimated energy transmission efficiency.

2. The method for monitoring the wind turbine generator (1) according to claim 1,
wherein the monitoring object part is a hydraulic transmission (10) including a hydraulic pump (11) and a hydraulic motor (12) and located on the energy transmission pathway, and
wherein in the calculation step, the energy transmission efficiency is calculated from the input energy to the hydraulic transmission (10) and the output energy from the hydraulic transmission (10), the input energy being obtained from torque and rotation speed of a main shaft (8) coupled to the rotor (4), the output energy being obtained from torque and rotation speed of an output shaft (17) of the hydraulic motor (12).

3. The method for monitoring the wind turbine generator (1) according to claim 1,
wherein the monitoring object part is the generator (18), and
wherein in the calculation step, the energy transmission efficiency is calculated from the input energy to the generator (18) and the output energy from the generator (18), the input energy being obtained from torque and rotation speed of an input shaft of the generator, the output energy being obtained from power generated in the generator (18).

4. The method for monitoring the wind turbine generator (1) according to claim 1,
wherein the monitoring object part is the rotor (4), and
wherein in the calculation step, the energy transmission efficiency is calculated from the input energy to the rotor (4) and the output energy from the rotor (4), the input energy being obtained from a wind direction and wind speed of the wind and a pitch angle of the blade (5), the output energy being obtained from torque and rotation speed of the main shaft (8).

5. The method for monitoring the wind turbine generator (1) according to claim 1, further comprising:
a cause determination step of determining a cause of decline in the energy transmission efficiency based on the temporal change.

6. A method for monitoring a wind turbine generator (1) comprising and configured to generate power by transmitting energy of wind from a rotor (4) having a blade (5) and a hub (6) to which the blade (5) is mounted to a generator (18) via an energy transmission pathway arranged from the rotor (4) to the generator (18), the method **characterized by**:
a calculation step of calculating energy transmission efficiency in a monitoring object part from input energy inputted to the monitoring object part and output energy outputted from the monitoring object part, the monitoring object being located on the energy transmission pathway; and
a decision step of deciding necessity for maintenance based on the energy transmission efficiency.

7. A monitoring system for a wind turbine generator (1) configured to generate power by transmitting energy of wind from a rotor (4) having a blade (5) and a hub (6) to which the blade (5) is mounted to a generator (18) via an energy transmission pathway arranged from the rotor (4) to the generator (18), the monitoring system **characterized by**:
a calculation unit (21) for calculating energy transmission efficiency in a monitoring object part located on the energy transmission pathway from input energy inputted to the monitoring object part and output energy outputted from the monitoring object part;
a temporal-change obtaining unit (22) for obtaining temporal change of the energy transmission efficiency from past energy transmission efficiency calculated by the calculation unit;
an estimation unit (23) for estimating energy transmission efficiency in the future based on the temporal change; and
a determination unit (24) for determining maintenance timing based on the estimated energy transmission efficiency.
